Europäisches Patentamt

European Patent Office

Office européen des brevets

(19)

(11) **EP 1 157 868 B1**

(12) **EUROPÄISCHE PATENTSCHRIFT**

(45) Veröffentlichungstag und Bekanntmachung des Hinweises auf die Patenterteilung:
**09.07.2003 Patentblatt 2003/28**

(51) Int Cl.$^7$: **B60H 1/22**, H05B 3/22, H05B 1/02, H05B 3/50

(21) Anmeldenummer: **00112394.2**

(22) Anmeldetag: **09.06.2000**

(54) **Elektrische Heizvorrichtung**

Electrical heating device

Dispositif de chauffage électrique

(84) Benannte Vertragsstaaten:
**AT BE CH CY DE DK ES FI FR GB GR IE IT LI LU MC NL PT SE**

(30) Priorität: **23.05.2000 EP 00111120**

(43) Veröffentlichungstag der Anmeldung:
**28.11.2001 Patentblatt 2001/48**

(73) Patentinhaber: **Catem GmbH & Co.KG**
**76863 Herxheim bei Landau/Pfalz (DE)**

(72) Erfinder:
• **Beetz, Klaus, Dr.**
**76149 Karlsruhe (DE)**
• **Bohlender, franz**
**76870 Kandel/Pfalz (DE)**

(74) Vertreter: **Grünecker, Kinkeldey,**
**Stockmair & Schwanhäusser Anwaltssozietät**
**Maximilianstrasse 58**
**80538 München (DE)**

(56) Entgegenhaltungen:
**EP-A- 0 901 311        DE-A- 19 845 401**

EP 1 157 868 B1

**Beschreibung**

Die Erfindung betrifft eine elektrische Heizvorrichtung gemäß dem Oberbegriff des Patentanspruchs 1. Eine solche elektrische Heizvorrichtung eignet sich insbesondere für den Einsatz als elektrische Zusatzheizung für Kraftfahrzeuge.

Elektrische Heizungen werden in Kraftfahrzeugen beispielsweise zur Erwärmung der Innenraumluft, zur Vorheizung von Kühlwasser bei wassergekühlten Motoren oder Erwärmung von Kraftstoff verwendet. Derartige Zusatzheizungen bestehen üblicherweise aus mindestens einer Heizstufe mit Heizelementen und einer Steuervorrichtung. Die Heizelemente sind in der Regel als elektrischer Heizwiderstand, insbesondere als PTC-Element ausgebildet. Die Heizung und die Steuereinheit können sowohl als getrennte Funktionseinheiten ausgebildet als auch zu einer Baueinheit zusammengefasst sein.

Nachteilig an einer getrennten Ausbildung ist, dass Verbindungsleitungen zwischen Heizung und Kontrolleinheit erforderlich sind, die zum Teil erhebliche Ströme zu leiten haben. Außerdem muss die in der Steuereinheit erzeugte Verlustleistung gesondert abgeführt werden.

Aus gattungsgemäßer EP-A2-0 901 311 ist eine elektrische Heizeinrichtung für Kraftfahrzeuge bekannt. Die beschriebene Zusatzheizung umfasst mehrere zu einem Heizblock zusammengesetzte Heizelemente. Der Heizblock wird zusammen mit einer Steuervorrichtung zur Ansteuerung der Heizelemente in einem gemeinsamen Rahmen gehalten. Auf diese Weise bildet die Steuervorrichtung mit dem in dem Rahmen gehaltenen Heizblock eine bauliche Einheit Die Steuervorrichtung umfasst eine Leistungselektronik mit elektronischen Schaltern, die Kühlkörper aufweisen.

EP-A2-0 837 381 beschreibt eine elektrische Heizung, bei der sowohl die Heizelemente als auch eine Steuereinrichtung in einer Baueinheit angeordnet sind. In diesem Dokument sind verschiedene Steuerungskonzepte für elektrische Zusatzheizungen beschrieben.

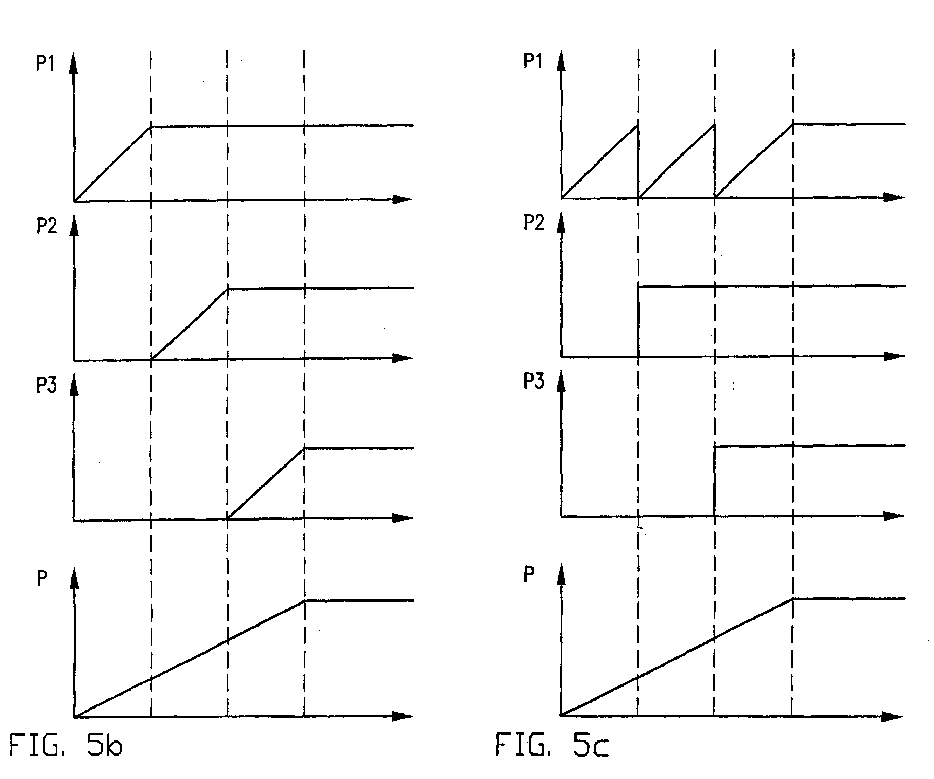

Die einfachste Leistungsregelung für eine Zusatzheizung aus mehreren einzelnen, voneinander getrennten Heizkreisen besteht aus einer gleichzeitigen Ansteuerung der Heizstufen. Eine solche Ansteuerung am Beispiel von drei Heizstufen ist in Fig. 5a dargestellt. Die Leistungen P1, P2 und P3 der einzelnen Heizstufen sind jeweils separat dargestellt. Bei steigendem Heizbedarf werden die Heizstufen gleichmäßig ausgesteuert, so dass jede der einzelnen Stufen eine zunehmend größere Heizleistung erbringt. Die Gesamtheizleistung P ist im untersten Diagramm der Fig. 5a dargestellt. Die Gesamtleistung P entspricht der Summe der Einzelheizleistungen P1 bis P3.

Eine solche Ansteuerung ermöglicht eine gleichmäßig verteilte Aufheizung der gesamten Zusatzheizung. Nachteilig an einer solchen Leistungsregelung ist jedoch, dass in der Steuervorrichtung für alle Heizstufen gleichzeitig eine hohe Verlustleistung entsteht.

Die Verlustleistung, die in der Steuerungsvorrichtung entsteht, kann dann vermindert werden, wenn die von jedem Heizkreis bzw. Heizelement abzugebende Leistung separat einstellbar ist. Dazu werden die einzelnen Heizstufen unabhängig voneinander angesteuert und bei steigendem Heizbedarf sequentiell aufgeregelt.

Wie in Fig. 5b dargestellt, werden bis auf eine Heizstufe alle anderen entweder mit Nulllast oder mit Volllast betrieben. Bei geringem Heizbedarf wird zunächst eine erste Heizstufe bis zum Volllastbetrieb aufgeregelt. Bei weiter steigendem Heizbedarf wird zusätzlich eine zweite Heizstufe aufgeregelt. Anschließend kann auch noch die dritte Heizstufe aufgeregelt werden, bis alle Heizstufen mit voller Heizleistung betrieben werden. Die Gesamtheizleistung P steigt dabei, wie im untersten Diagramm in Fig. 5b dargestellt, in derselben Weise, wie bei der gleichzeitigen Ansteuerung der Heizstufen gem. Fig. 5a, an.

Vorteilhaft an dieser Leistungsregelung ist, dass nur jeweils die nicht im Volllastbetrieb befindliche Heizstufe eine höhere Verlustleistung erzeugt, während die anderen Heizstufen nur eine geringe Verlustleistung verursachen.

In DE-A-198 45 401 ist ein elektrisches Heizelement mit einer Mehrzahl von Heizwiderständen und entsprechenden Reglern beschrieben. Dabei wird ein Regler im Linearbetrieb betrieben und die anderen sind entweder deaktiviert oder im Sättigungsbetrieb.

Aufgabe der Erfindung ist es, eine verbesserte elektrische Heizvorrichtung anzugeben.

Diese Aufgabe wird mit den Merkmalen des Patentanspruchs 1 gelöst.

Bei der erfindungsgemäßen elektrischen Heizvorrichtung ist nur die Heizleistung einer Heizstufe bzw. eines Heizelementes variabel einstellbar. Alle weiteren Heizstufen können nur zu- oder abgeschaltet werden. Auf diese Weise wird eine aufwendige Ansteuerung aller Heizstufen vermieden und die Verlustleistung kann besonders klein gehalten werden. Da die Steuervorrichtung und das zu erwärmende Medium eine bauliche Einheit bilden, wird die Verlustwärme der Steuervorrichtung ebenfalls an das zu erwärmende Medium abgegeben. Eine Verlustleistung im eigentlichen Sinne wie bei herkömmlichen Heizvorrichtungen entsteht bei dem erfindungsgemäßen Aufbau daher nicht.

Vorteilhafte Ausgestaltungen der Erfindung sind Gegenstand der Unteransprüche.

Die Erfindung wird im folgenden anhand der beiliegenden Figuren beschrieben, in denen:

Fig. 1a und 1b eine Aufsicht bzw. Seitenansicht einer erfindungsgemäßen elektrischen Zusatzheizung zeigen,

Fig. 2 die Grundschaltung einer erfindungsgemäßen elektrischen Schaltvorrichtung mit drei elektrischen Heizelementen zeigt,

Fig. 3 eine Detailansicht des kastenförmig ausgebildeten Seitenholms und der in diesen einsetzbaren Steuervorrichtung zeigt,

Fig. 4 eine weitere Detailansicht des kastenförmig ausgebildeten Seitenholms und der in diesen einsetzbaren Steuervorrichtung zeigt,

Fig. 5a, 5b und 5c unterschiedliche Steuerungskonzepte für die Ansteuerung von drei Heizelementen bei zunehmender Heizleistung zeigen,

Fig. 6a und 6b Beispiele für eine getaktete Steuerung der Heizleistung angeben,

Fig. 7a und 7b Beispiele für eine zeitversetzte Ansteuerung wiedergeben, und

Fig. 8 ein Beispiel für eine Modulation mit einer alternativen Kurvenformen zeigt.

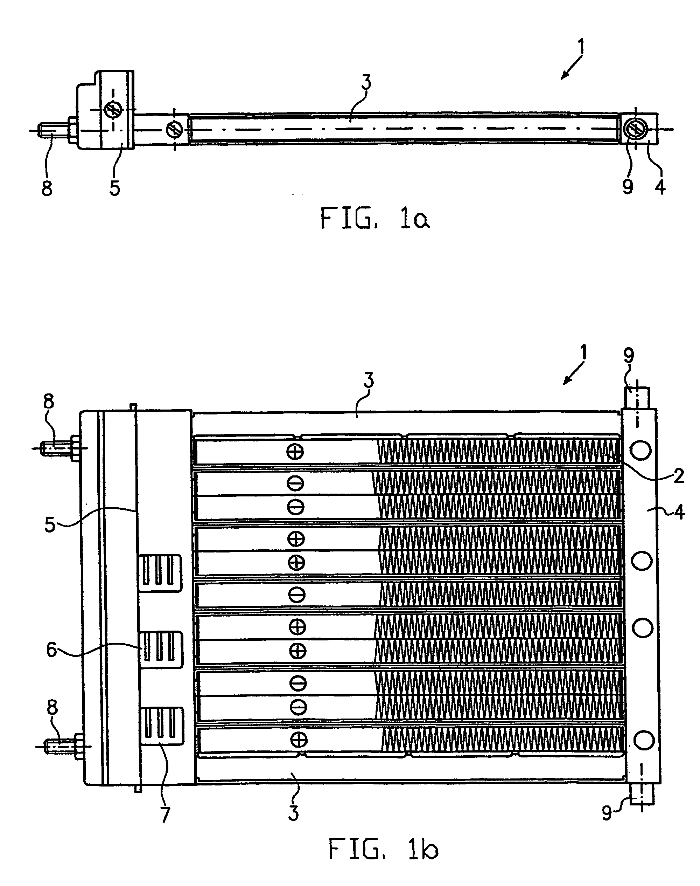

In Fig. 1a ist eine Seitenansicht der erfindungsgemäßen elektrischen Zusatzheizung 1 gezeigt, die insbesondere für den Einsatz in Kraftfahrzeugen geeignet ist. Fig. 1b zeigt eine Aufsicht auf die elektrische Zusatzheizung 1. Die elektrische Zusatzheizung 1 enthält einen Heizblock, der aus einer Mehrzahl geschichteter oder gestapelter Heizelemente 2 besteht Jedes Heizelement 2 besteht aus einem Widerstandsheizelement und benachbart dazu angeordneten Radiatoren oder Wärmeleitblechen. Als Widerstandsheizelemente werden vorzugsweise PTC-Elemente verwendet Der Heizblock aus den Heizelementen 2 wird in einem Rahmen gehalten. Dieser Rahmen besteht aus gegenüberliegenden Längsholmen 3 und senkrecht dazu angeordneten Seitenholmen 4 und 5. Die Holme des Rahmens werden entweder aus Metall oder aus Kunststoff gefertigt.

Während die Längsholme 3 im wesentliche symmetrisch aufgebaut sind, unterscheiden sich die beiden Seitenholme 4 und 5 in der in Fig. 1 dargestellten Ausführungsform.

Im Gegensatz zum Seitenholm 4 ist der Seitenholm 5 als einseitig offener Kasten ausgebildet. Die Öffnung dieses kastenförmigen Seitenholms 5 liegt auf der den Heizelementen 2 gegenüberliegenden Seite des Seitenholms 5. In diesen Kasten ist eine Steuervorrichtung einsetzbar, die die Wärmeabgabe der einzelnen Heizelemente 2 durch Steuerung des den Heizelementen 2 zugeführten Stromes steuert. Die offene Seite des als Kasten ausgebildeten Seitenholms 5 wird nach dem Einsetzen der Steuerschaltung mit einem aufsteckbaren oder aufklipsbaren Deckel verschlossen.

Die Platine 10 der Steuervorrichtung ist nach dem Einsetzen vorzugsweise senkrecht zur Rahmenebene angeordnet, es ist jedoch auch eine parallele Anordnung möglich (nicht dargestellt).

Die Zusatzheizung 1 wird über zwei Anschlussbolzen 8 mit Strom versorgt. Sie sind so ausgebildet, dass sie problemlos die geforderten Heizströme leiten können. Die Anschlussbolzen 8 ragen in der in Fig. 1 dargestellten Ausführungsform auf der Seite heraus, auf der der kastenförmige Seitenholm 5 offen ist.

Auf derselben Seite ist ein weiterer Steckersockel zur Ansteuerung der Steuervorrichtung vorgesehen, der in Fig. 1 nicht dargestellt ist.

Der Seitenholm 5 weist auf den Seiten, die in der Flächenebene des Rahmens liegen, Fensteröffnungen 7 auf. Diese Fensteröffnungen sind so angeordnet, dass sie ebenfalls in dem zu erwärmenden Luftstrom liegen. Zwischen den sich gegenüberliegenden Fensteröffnungen 7 sind Kühlelemente 6 angeordnet, die zu den Leistungselektronikbauelementen der Steuerschaltung gehören. Beim Betrieb wird nicht nur der Heizblock aus den Heizelementen 2, sondern ebenfalls die Fensteröffnungen 7 von zu erwärmender Luft durchsetzt.
Die Wahl der Größe der Fensteröffnungen 7 erlaubt, den Anteil der Luftmenge zu bestimmen, die an den Kühlelementen 6 vorbeiströmt. Der Luftdurchsatz wird so eingestellt, dass die durch den Heizblock geströmte Luft und die an den Kühlkörpern 6 vorbeigeströmte Luft möglichst geringe Temperaturunterschiede aufweisen. Nur wenn die durch die Fensteröffnungen 7 geströmte Luft in ihrer Temperatur der durch den Heizblock geströmten Luft möglichst nahe kommt, wird eine möglichst hohe Effizienz beim Betrieb der Zusatzheizung erreicht.

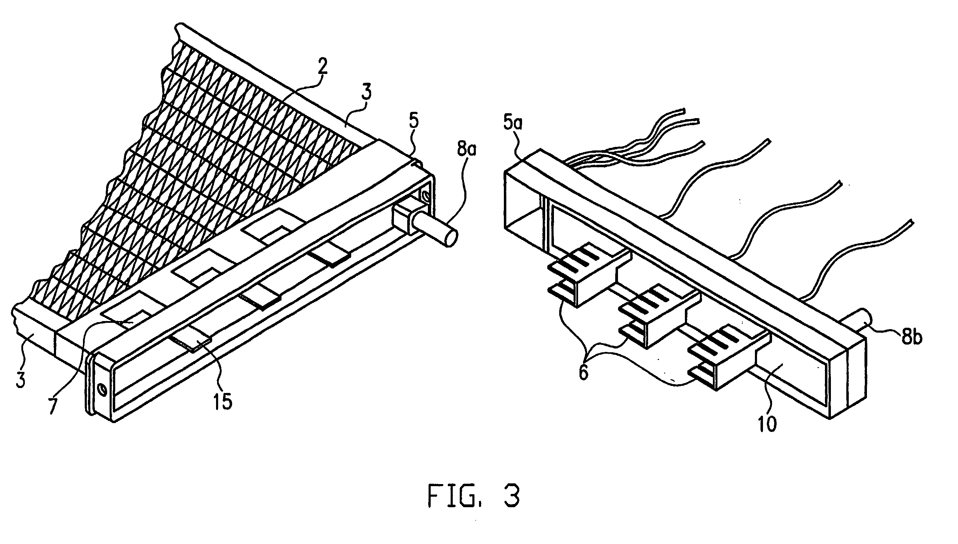

Figur 3 zeigt eine Detailansicht des kastenförmig ausgebildeten Seitenholms 5 und der in diesen einsetzbaren Steuerschaltung. Der Seitenholm 5 ist auf einer Seite mit den Längsholmen 3 und dem Heizblock mit den Heizelementen 2 verbunden. Auf der Oberseite des Seitenholms 5 sind die fensterförmigen Öffnungen 7 zu erkennen, durch die die zu erwärmende Luft hindurchtritt.

Innerhalb des kastenförmig ausgebildeten Seitenholms 5 sind drei Anschlusslaschen 15 zu erkennen und ein Anschlussbolzen 8a. Dieser Anschlussbolzen stellt die Plusverbindung für alle Heizelemente 2 dar. Zusätzlich ist in dieser Abbildung in perspektivischer Darstellung die Steuervorrichtung 5a zu erkennen, die in den Kasten des Seitenholmes 5 einsetzbar ist. Die Steuervorrichtung 5a wird mit der dem Seitenholm 5 zugewandten Seite in diesen eingesetzt.

Auf der dem Seitenholm 5 zugewandten Seite der Steuervorrichtung 5a ist die Unterseite der Platine 10 zu erkennen. Aus dieser Platine 10 ragen drei Kühlelemente 6 heraus. Jedes dieser Kühlelemente bzw. Kühlbleche ist einem der Leistungstransistoren 11 einer Heizstufe zugeordnet.

Zu jedem Kühlelement 6 sind entsprechende Fensteröffnungen 7 in der Oberfläche des Seitenholms 5 vorgesehen. Dadurch wird im Betrieb jedem Kühlelement gezielt ein Luftstrom zugeführt.

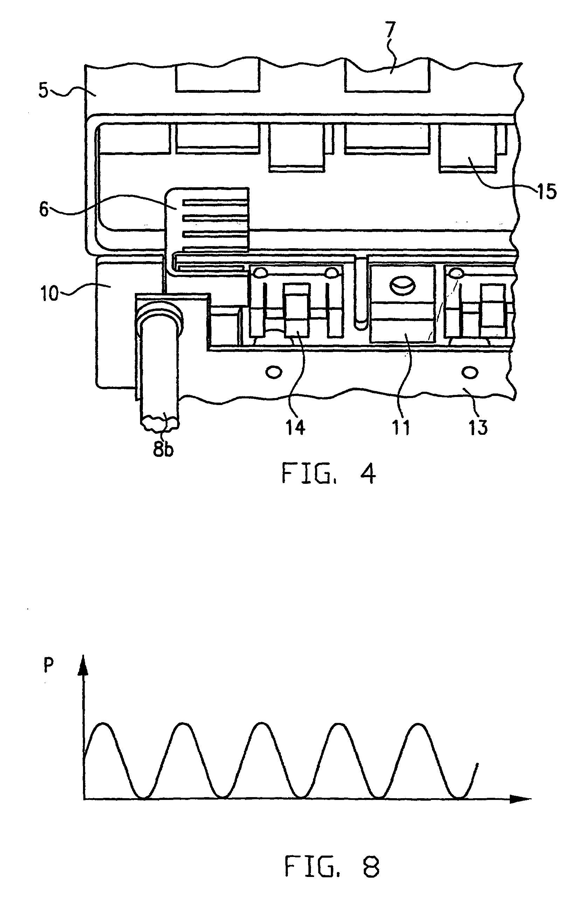

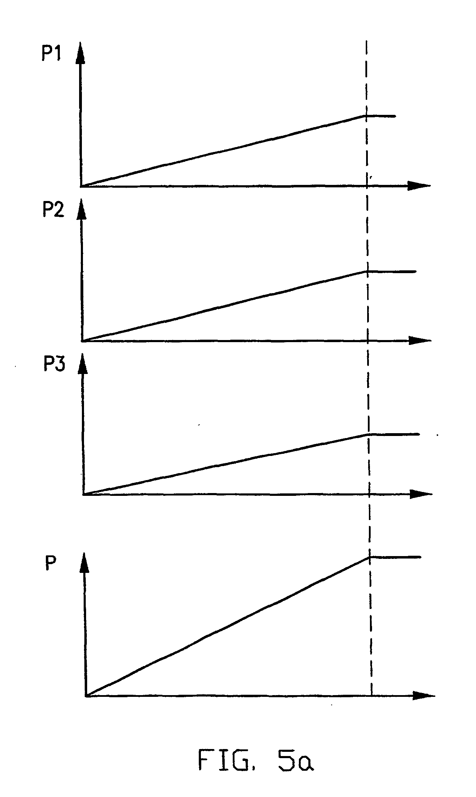

Auf der nach außen gewandten Seite ist ein weiterer Anschlussbolzen 8b zu erkennen. Dieser Anschlussbolzen dient als elektrischer Massepol bei der Zuführung von Strom. Der Anschlussbolzen 8b ist mit der in Fig. 4 dargestellten Leitungsschiene 13 verbunden, die den Heizstrom einzelnen Heizstufen zuführt. Jeder einzelne der Heizstufen entnimmt über ihren Leistungstransistor 11 die notwendige Strommenge aus der Leitungsschiene 13.

In Fig. 4 ist eine weitere perspektivische Detailansicht des Seitenholms 5 und der in die kastenförmige Öffnung des Seitenholms 5 einsteckbaren Steuerschaltung dargestellt.

Im oberen Bereich der Fig. 4 sind auf der Oberfläche des Seitenholms 5 zwei der Fensteröffnungen 7 zu erkennen. Diese Fensteröffnungen sind so angeordnet, dass sie ober- und unterhalb der Kühlelemente 6 liegen, wenn die Steuerschaltung in den Seitenholm 5 eingesetzt ist: Für eine gezielte Lenkung des Luftstroms zwischen den Fensteröffnungen 7 können in dem Seitenholm 5 zusätzliche Wände vorgesehen sein, die in den Figuren nicht dargestellt sind.

Innerhalb der kastenförmigen Öffnung des Seitenholms 5 sind die Anschlusslaschen 15 der Heizelemente 2 zu erkennen. Für jede Heizstufe ist eine Anschlusslasche 15 vorgesehen.

In der unteren Hälfte der Fig. 4 ist die in den Seitenholm 5 einsetzbare Steuerschaltung dargestellt. Nur einer der Leistungstransistoren 11 ist in diesem Fall zur besseren Deutlichkeit des Aufbaus mit einem Kühlelement 6 versehen.

Auf einer Platine 10 ist neben den Leistungselektronikbauelementen 11 eine Steuerelektronik vorgesehen. Die Steuerelektronik bestimmt die von den Leistungselektronikbauelementen 11, insbesondere den Leistungstransistoren, an das diesen jeweils zugeordnete Heizelement 2 abzugebende Strommenge. Die Strommenge wird der Steuerschaltung von einem der Anschlussbolzen 8 über eine Leitungsschiene 13 zugeführt. Der Ausgang des Leistungstransistors 11 ist fest mit der Platine 10 verlötet und mit dem diesem Transistor zugeordneten Federelement 14 verbunden.

Die Federelemente 14 sind so auf der Platine angebracht, dass sie beim Zusammenstecken der Steuervorrichtung in den Seitenholmen 5 mit den Anschlussfahnen 15 der Heizelemente 2 verbunden sind.

In der dargestellten Ausführungsform werden die Anschlussfahnen 15 durch die Platine 10 hindurch in die Federelemente 14 gesteckt. Eine solche Anordnung erlaubt eine feste mechanische Fixierung der Platine 10 mit der Steuerelektronik in dem Rahmen. Gleichzeitig wird eine elektrische Kontaktierung mit den jeweiligen Heizelementen bewirkt.

Die Platine 10 ist nur einseitig mit Bauelementen bestückt. Entsprechend der Anzahl von Heizstufen weist die Platine waagerecht auf dieser befestigte Leistungstransistoren 11 auf. Im Ausführungsbeispiel sind drei Heizstufen und dementsprechend drei Leistungstransistoren vorgesehen. Jeder Leistungstransistor 11 ist an seinem Ausgangsanschluss fest mit der Platine 10 verlötet.

Aus dem Transistor ragt eine Anschlussfahne heraus, an der ein Kühlelement 6 befestigt ist. Das Kühlelement 6 ist vorteilhafterweise nicht elektrisch leitend mit dem Heizelement verbunden.

Das Kühlelement 6 weist Kühlrippen auf, die in einer Ebene liegen, die senkrecht auf der Platine steht. Im gezeigten Ausführungsbeispiel sind die Kühlrippen zudem auf der nicht bestückten Seite der Platine angeordnet. Nur ein Schenkel des Kühlelementes 6 ragt auf die bestückte Seite der Platine und ist mit der Anschlussfahne des Transistors 11 verbunden, um die vom Transistor erzeugte Wärme abzuleiten. In der gezeigten Ausführungsform ragt der mit dem Transistor 11 verbundene Schenkel des Kühlelementes 6 durch eine Öffnung in der Platine 10 auf die bestückte Seite der Platine 10. Diese Öffnungen in Fig. 4 jeweils links von den Transistoren 11 angeordnet zu erkennen. Er kann jedoch ebenfalls über den Rand der Platine ragen, so dass eine Öffnung in der Platine 10 nicht erforderlich ist.

Eine entsprechende Anordnung der Bauelemente von Transistor 11, Federelement 14 und Kühlelement 6 ist jeweils für jede Heizstufe auf der Platine vorgesehen.

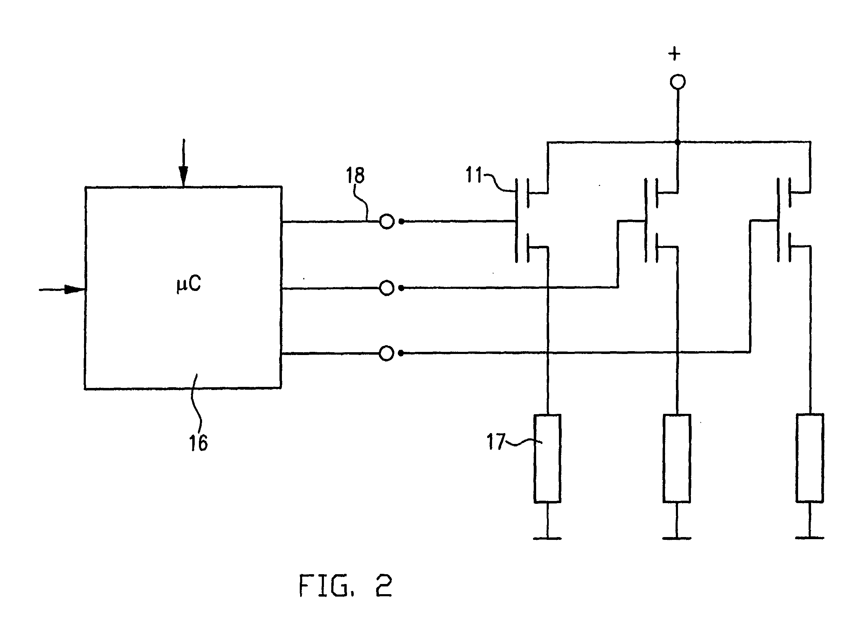

Die Grundschaltung einer elektrischen Heizvorrichtung als Zusatzheizung gemäß der vorliegenden Erfindung ist in Fig. 2 dargestellt Eine Recheneinheit 16, vorzugsweise ein Mikrocomputer, steuert die Heizleistung mehrerer elektrischer Heizwiderstände 17. Die hohen Ströme, die zur Erzielung einer Gesamtheizleistung im Bereich von 1000 bis 2000 Watt erforderlich sind, werden über Leistungshalbleiter 11, insbesondere Leistungstransistoren, den elektrischen Heizwiderständen 17 zugeführt. Welche Strommenge von den Transistoren 11 an die Widerstände 17 geleitet wird, bestimmt die Steuervorrichtung 16 in Abhängigkeit von dem verwendeten Steuerverfahren und vorgegebenen Sollwerten. Dazu ist die Recheneinheit 16 über Leitungen 18 separat mit jedem der Leistungstransistoren 11 verbunden.

Die Gesamtheizleistung, die von den Heizwiderständen 17 erzeugt wird, regelt die Recheneinheit 16 in Abhängigkeit von der erwünschten Heizleistung. Zusätzlich kann auch die maximal zur Verfügung stehende Generatorleistung in einem Kraftfahrzeug bei der Steuerung mitberücksichtigt werden.

In welcher Weise jeder der einzelnen Heizwiderstände zur Gesamtheizleistung beiträgt, hängt von dem gewählten Leistungsregelungskonzept ab.

Gemäß dem Stand der Technik ist es bekannt, mehrere, unabhängige Heizstufen je nach gewünschter Gesamtheizleistung gleichmäßig auszusteuern (vgl. Fig. 5a) oder jede Heizstufe sequentiell aufzuregeln (vgl. Fig. 5b). Beide bekannte Regelungskonzepte haben jedoch die folgenden Nachteile. Bei der gleichmäßigen Aufregelung aller Heizelemente (Fig. 5a) wird abhängig von der eingestellten Heizleistung jeweils eine relativ hohe Verlustleistung erzeugt. Gemäß der in Fig. 5b dargestellten sequentiellen Aufregelung separater Heizelemente wird die Verlustleistung vermindert, indem ein weiteres Heizelement erst dann aktiv wird, wenn ein Vorhergehendes die erwünschte Heizleistung nicht mehr allein bewirken kann.

Mit einem solchen Leistungsregelungskonzept wird zwar die Verlustleistung der Steuervorrichtung deutlich vermindert, jedoch der Steuerungsaufwand selbst erhöht. Zudem benötigen beide bekannte Regelungskonzepte separate lineare Regler für jede Heizstufe.

Diese beiden Nachteile lassen sich vermeiden, in dem das in Fig. 5b dargestellte Regelungskonzept weiter verbessert wird. Dazu werden die Heizstufen bei steigendem Heizleistungsbedarf nicht aufeinanderfolgend hochgeregelt, sondern nur eine einzige Heizstufe ist regelbar ausgestaltet. Alle weiteren zusätzlichen Heizstufen sind entweder nur unter Volllast oder Nulllast betreibbar. Diese Heizstufen können je nach Bedarf zu- bzw. abgeschaltet werden. Für eine entsprechende "Feinabstimmung" der zu erbringenden Heizleistung wird die regelbare Heizstufe mit einem variablen Beitrag zugeschaltet. Die Heizleistung dieser Heizstufen ist kontinuierlich einstellbar (in der Regel über eine Vielzahl diskreter Werte). Ein solches Regelungskonzept ist in Fig. 5c dargestellt.

Eine entsprechende Steuerschaltung ist dadurch weniger aufwendig als herkömmliche, denn eine variable Ansteuerung ist bloß für eine Heizstufe erforderlich. Alle weiteren können durch einen einfachen (elektronischen) Schalter zu- bzw. abgeschaltet werden.

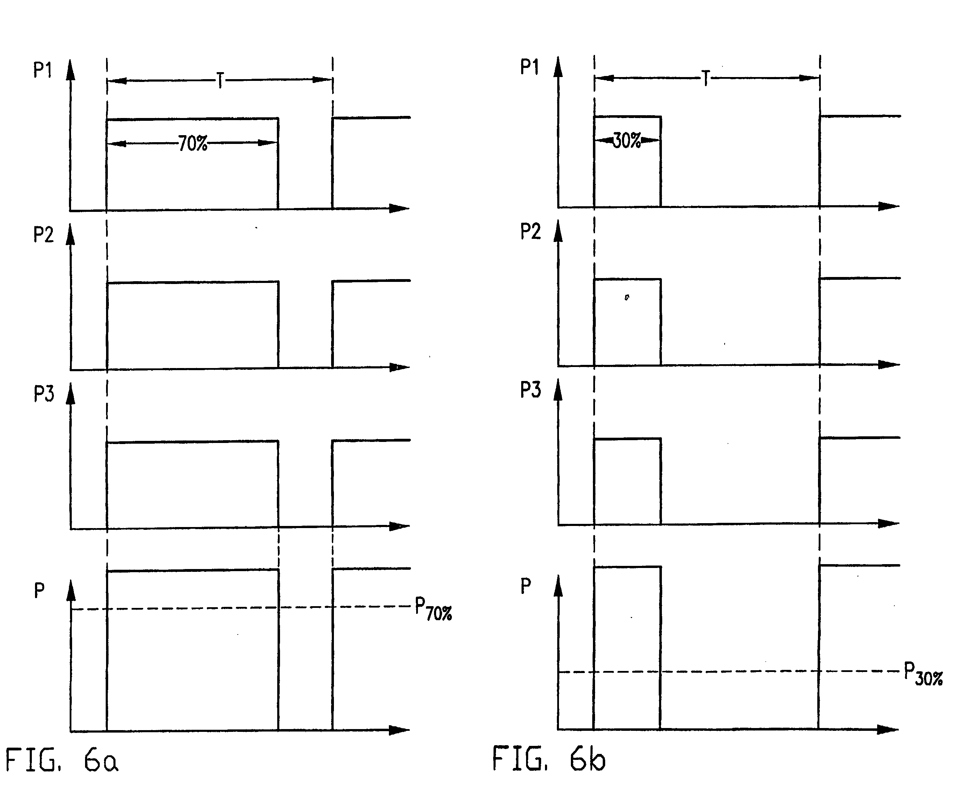

Eine getaktete Ansteuerung ist allgemein in Verbindung mit den Fig. 6a und 6b beschrieben. Die Heizvorrichtung besteht dabei wiederum vorzugsweise aus drei voneinander getrennten Heizkreisen mit elektrischen Heizwiderständen 17. Die Heizleistung jedes einzelnen Widerstands 17 ist mit P1, P2 und P3 angegeben. Die resultierende Gesamtheizleistung ergibt sich im untersten Diagramm jeweils zu P.

Jeder Heizkreis wird von der Steuereinrichtung 1 mit einer festen Frequenz f mit der Periode T getaktet. Die Leistung jedes einzelnen Heizelementes 17 ergibt sich dabei aus dem Tastverhältnis. Durch eine Modulation der Breite der Pulse ist es möglich, die Heizleistung stufenlos zu variieren. Die Trägheit der Heizelemente aus Heizwiderständen und Wärmeleitelementen (beispielsweise Radiatoren) bei der Wärmeleitung bewirkt eine der gemittelten Heizleistung entsprechende Temperatur. Die Schwankungen der Temperatur der Heizelemente sind daher im Vergleich zu denen der Ströme vernachlässigbar.

Die in Fig. 6a gezeigte Leistungsregelung entspricht prinzipiell der unter Bezugnahme auf Fig. 5a beschriebenen linearen Aussteuerung. Demgemäss werden zur Erzeugung einer vorgegebenen Gesamtheizleistung alle Heizelemente gleichmäßig ausgesteuert. Bei zunehmender Gesamtheizleistung nimmt die Heizleistung aller einzelnen Heizelemente entsprechend zu.

In Fig. 6a ist beispielsweise ein Tastverhältnis von 70% für jeden der Impulse angegeben. Es wird also demgemäss 70% der maximal möglichen Heizleistung erzeugt.

Im untersten Diagramm gibt die gestrichelte Linie mit der Bezeichnung $P_{70\%}$ die gemittelte effektive Heizleistung aller Heizelemente an, während die durchgezogene Linie jeweils die Momentanleistung anzeigt. In Fig. 6b ist eine entsprechende Ansteuerung für eine 30%-ige Gesamtheizleistung wiedergegeben.

Eine zeitlich synchron erfolgende Tastung der verschiedenen Heizelemente führt jedoch bei jedem Taktvorgang zu einem sprunghaften Anstieg der von der Zusatzheizung entnommenen Generatorleistung bzw. zu einem ebenso sprunghaften Abfall. Diese Umschaltung zwischen Nulllast und Volllast mit jedem Takt führt zu einer unregelmäßigen und störenden Belastung des Generators. Die starken Schwankungen der Momentangesamtleistung wird von den durchgezogenen Linien in den untersten Diagrammen in Fig. 6a und 6b wiedergegeben.

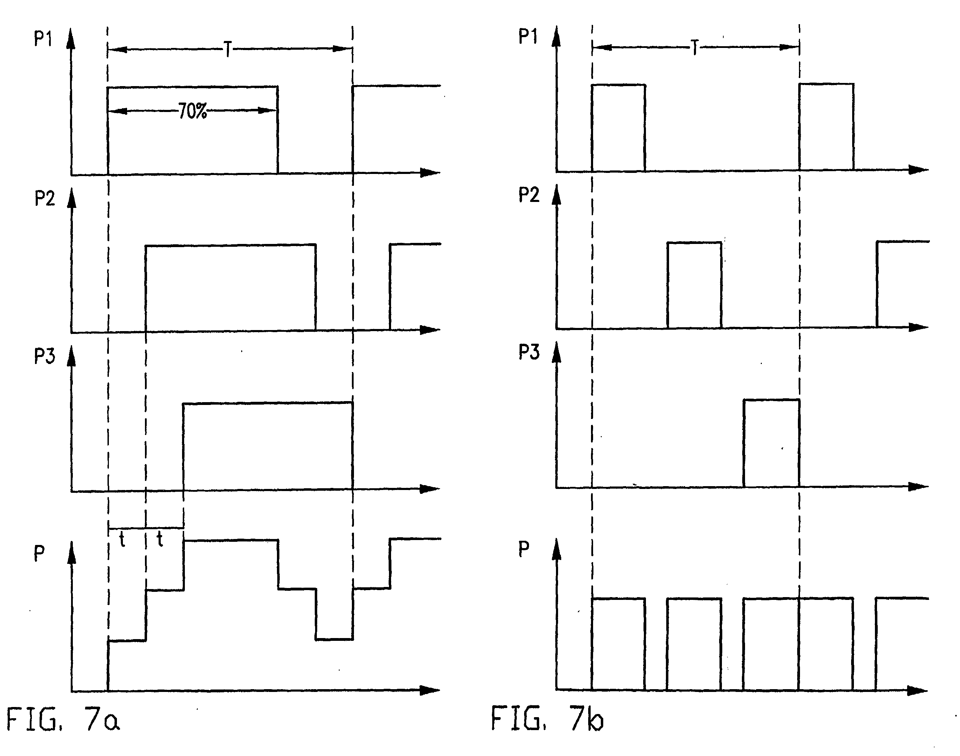

Um solche zeitlichen Schwankungen in der Wärmeabgabe zu vermeiden, werden bei Verwendung mehrerer Heizstufen diese vorzugsweise zeitlich versetzt getaktet. In Fig. 7a und 7b sind Beispiele für einen solchen zeitlichen Versatz dargestellt. Die drei Heizstufen werden mit einem zeitlichen Versatz t getaktet. Dabei ist die jeweilige aktive Impulsbreite der einzelnen Heizstufen über eine ganze Periode T eines Taktes verteilt. Auf diese Weise wird die Gesamtheizleistung zeitlich sehr viel gleichmäßiger erzeugt. In Fig. 7a und 7b ist eine im Vergleich zu den Fig. 6a und 6b relativ konstante Momentan-Gesamtheizleistung im untersten Diagramm zu erkennen.

Die verschiedenen Heizkreise werden gemäß Fig. 7 sequentiell mit einem vorbestimmten zeitlichen Versatz innerhalb einer Frequenzperiode angesteuert. Auf diese Weise wird eine gleichzeitige Stromverdopplung und damit eine erhöhte Belastung für einen (Kraftfahrzeug)-Generator vermieden. Idealerweise erfolgt die Ansteuerung einer weiteren Heizstufe jeweils in den Strompausen der weiteren Heizstufen, wie in Fig. 7b gezeigt. Ein gleichmäßiger Zeitversatz innerhalb einer Periode T ergibt sich bei einem Zeitversatz t gemäß folgender Formel

$$t = \frac{1 - TV}{n - 1}$$

wobei *TV* das Tastverhältnis angibt und *n* die Anzahl der verwendeten Heizstufen.

Dadurch, dass die aktiven Pulsbreiten über die gesamte Dauer einer Periode T verteilt werden, kann auch bei unterschiedlichen Tastverhältnissen eine möglichst kontinuierliche Belastung erzeugt werden. In Fig. 7b ist ein nahtloser Anschluss des Gesamtstroms im untersten Diagramm, das die Gesamtheizleistung P wiedergibt, beim Übergang vom letzten Impuls einer Periode T vom dritten Heizelement zu dem ersten Impuls einer neuen Periode T vom ersten Heizelement zu erkennen.

Bis zu einer Heizleistung von P/n jeder einzelnen Stufe können die "aktiven" Impulse der Einzelstufen so aufeinanderfolgen, dass ein nahezu konstanter Stromfluss entsteht und nur eine geringe Anzahl von Stromflusssprüngen erforderlich ist.

Das Konzept der getakteten Aussteuerung läßt sich auch auf die erfindungsgemäße Leistungssteuerung übertragen. Dazu ist die Heizleistung einer Stufe kontinuierlich durch Einstellung des Tastverhältnisses TV regelbar. Weitere Heizstufen werden je nach Bedarf zu- bzw. abgeschaltet. Eine solche Regelung hat den Vorteil, dass nur eine Stufe getaktet wird und damit der Steuerungsaufwand vermindert wird. Stromverdopplungen, wie bei der ersten Ausführungsform können dabei nicht auftreten.

In Fig. 8 ist ein Beispiel für eine alternative Kurvenform dargestellt, um den Strom, der einem Heizelement jeweils zugeführt wird, zu modulieren. Anders als die Rechteckfunktionen der vorhergehenden Beispiele können auch Modulationsfunktionen mit weniger sprunghaftem Anstieg bzw. Abfall des Stromflusses verwendet werden. Als Beispiel ist in Fig. 8 eine sinusförmige Taktung wiedergegeben. Weitere, nicht dargestellte Funktionen sind ebenfalls möglich. Solche Kurven zeichnen sich dadurch aus, dass der Strom nicht nur zwischen einem Nulllastund einem Volllastbetrieb umgeschaltet wird, sondern auch Zwischenwerte annimmt.

**Patentansprüche**

1. Elektrische Heizvorrichtung, insbesondere als Zusatzheizung für Kraftfahrzeuge, mit

   mehreren zu einem Heizblock zusammengesetzten Heizelementen (2), wobei der Heizblock in einem rechteckigen Rahmen (3, 4, 5) gehalten ist, und

   einer Steuervorrichtung (5a) zur Ansteuerung der Heizelemente (2), die mit dem in dem Rahmen (3, 4, 5) gehaltenen Heizblock eine bauliche Einheit bildet, wobei die Heizleistung der Heizelemente (2) über den durch die Heizelemente (2) jeweils fließenden Strom einstellbar ist, wobei die Heizleistung der elektrischen Heizstufen separat einstellbar ist,

   **dadurch gekennzeichnet, dass**
   der Rahmen, in dem der Heizblock gehalten ist, aus sich gegenüberliegenden Längsholmen (3) und senkrecht zu diesen angeordneten Seitenholmen (4, 5) gebildet ist,
zumindest einer der Seitenholme (5) als einseitig offener Kasten ausgebildet ist, in den die Steuervorrichtung (5a) einsetzbar ist,
Fensteröffnungen (7) in dem Seitenholm (5) vorgesehen sind,
Kühlelemente (6) der Leistungstransistoren (11) bei eingesetzter Steuervorrichtung jeweils zwischen sich gegenüberliegenden Fensteröffnungen (7) liegen,
die Heizleistung einer der elektrischen Heizstufen kontinuierlich einstellbar ist und
die Heizleistung aller weiteren elektrischen Heizstufen jeweils nur zwischen der Maximalleistung und Nullleistung umschaltbar ist,

2. Elektrische Heizvorrichtung nach Anspruch 1, **dadurch gekennzeichnet, dass** die Steuervorrichtung (5a) zur Einstellung der Heizleistung der kontinuierlich einstellbaren Heizstufe den Strom mit einer Puls-Breiten-Modulation moduliert.

3. Elektrische Heizvorrichtung nach Anspruch 1 oder 2, **dadurch gekennzeichnet, dass** Mittel zur Beeinflussung der Luftströmung zwischen den sich gegenüberliegenden Fensteröffnungen (7) vorgesehen sind.

**Claims**

1. Electric heating device, in particular as supplementary heating for motor vehicles, with a plurality of heating elements (2) assembled to form a heating block, the heating block being held in a rectangular frame (3, 4, 5), and a control device (5a) for controlling the heating elements (2), which device forms a structural unit with the heating block held in the frame (3, 4, 5), the heat output of the heating elements (2) being adjustable via the current flowing respectively through the heating elements (2), the heat output of the electric heating stages being separately adjustable, **characterized in that** the frame in which the heating block is held is formed from opposing longitudinal struts (3) and lateral struts (4, 5) arranged at right angles to these, at least one of the lateral struts (5) is formed as a box open on one side, into which the control device (5a) is insertable, window openings (7) are provided in the lateral strut (5), cooling elements (6) of the power transistors (11) lie respectively between opposing window openings (7) when the control device is inserted, the heat output of one of the electric heating stages is continuously variable and the heat output of all other electric heating stages respectively can only be switched between the maximum output and zero output.

**2.** Electric heating device according to claim 1, **characterized in that** the control device (5a) for adjusting the heat output of the continuously variable heating stage modulates the current using pulse-width modulation.

**3.** Electric heating device according to claim 1 or 2, **characterized in that** means are provided for influencing the air flow between the opposing window openings (7).

**Revendications**

**1.** Dispositif de chauffage électrique, en particulier sous forme de chauffage d'appoint pour véhicules automobiles, avec

plusieurs éléments de chauffage (2) assemblés en un bloc de chauffage, le bloc de chauffage étant maintenu dans un cadre rectangulaire (3, 4, 5), et

un dispositif de commande (5a) pour diriger les éléments de chauffage (2), qui forme avec le bloc de chauffage maintenu dans le cadre (3, 4, 5) une unité de construction, la puissance de chauffage des éléments de chauffage (2) étant réglable au moyen du courant circulant respectivement à travers les éléments de chauffage (2), la puissance de chauffage des étages de chauffage électriques étant ainsi réglable séparément,

**caractérisé en ce que**

le cadre dans lequel le bloc de chauffage est maintenu est constitué de montants longitudinaux (3) opposés et de montants latéraux (4, 5) disposés de manière perpendiculaire à ceux-ci,

au moins l'un des montants latéraux (5) est conçu sous forme d'une caisse ouverte d'un côté, dans laquelle le dispositif de commande (5a) peut être introduit,

des ouvertures de fenêtre (7) sont prévues dans le montant latéral (5),

des éléments de refroidissement (6) des transistors de puissance (11) se trouvent, une fois le dispositif de commande inséré, respectivement entre des ouvertures de fenêtre (7) opposées,

la puissance de chauffage d'un des étages de chauffage électriques est continuellement réglable, et

la puissance de chauffage de chacun de tous les autres étages de chauffage électriques ne peut être commutée qu'entre la puissance maximale et la puissance zéro respectivement.

**2.** Dispositif de chauffage électrique selon la revendication 1, **caractérisé en ce que** le dispositif de commande (5a) pour le réglage de la puissance de chauffage de l'étage de chauffage continuellement réglable module le courant grâce à une modulation par largeur d'impulsions.

**3.** Dispositif de chauffage électrique selon la revendication 1 ou 2, **caractérisé en ce que** des moyens sont prévus pour influencer le courant d'air entre les ouvertures de fenêtre (7) opposées.

FIG. 1a

FIG. 1b

EP 1 157 868 B1

FIG. 2

FIG. 3

FIG. 4

FIG. 8

FIG. 5a

FIG. 5c

FIG. 5b

EP 1 157 868 B1

13

FIG. 6a

FIG. 6b

FIG. 7b

FIG. 7a